(19) Europäisches Patentamt
European Patent Office
Office européen des brevets

(11) **EP 4 329 113 A1**

(12) **EUROPEAN PATENT APPLICATION**

(43) Date of publication:
**28.02.2024 Bulletin 2024/09**

(21) Application number: **22191387.4**

(22) Date of filing: **22.08.2022**

(51) International Patent Classification (IPC):
**H01S 5/10** (2021.01)          **H01S 5/187** (2006.01)
**H01S 5/34** (2006.01)

(52) Cooperative Patent Classification (CPC):
**H01S 5/1075; H01S 5/187; H01S 5/3401**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ETH Zurich
8092 Zurich (CH)**

(72) Inventors:
• **FAIST, Jérôme
  8052 Zürich (CH)**
• **STARK, David
  9230 Flawil (CH)**

Remarks:
A request for correction of description page 8 has
been filed pursuant to Rule 139 EPC. A decision on
the request will be taken during the proceedings
before the Examining Division (Guidelines for
Examination in the EPO, A-V, 3.).

(54) **RING WAVEGUIDE QUANTUM CASCADE LASER**

(57)     A ring waveguide quantum cascade laser (1)
based on whispering gallery modes. The ring waveguide
(2) is bounded vertically upwards and downwards by refractive index differences between horizontally extending
semiconductor layers of a semiconductor stack (10-18)
including active region layers (14). The ring waveguide
(2) is bounded radially outwards by an outside sidewall
(31) that is covered with a dielectric-metal mirror (22, 24)
to reflect the whispering gallery modes back into the ring
waveguide and thereby reduce scattering losses. The
ring waveguide is bounded radially inwards by an inside
sidewall (33) that is a buried interface that interfaces with
a horizontally extending central layer (369 of insulating
semiconductor material to confine the carrier injection to
taking place vertically across the active region layers
(14).

Fig. 1B

**Description**

**BACKGROUND OF THE INVENTION**

The invention relates to quantum cascade lasers based on a ring waveguide which supports whispering gallery modes.

A quantum cascade laser (QCL) is based on a semiconductor heterostructure, i.e. a substrate and stack of semiconductor layers formed thereon. A QCL is based on cascading intraband transitions between subbands of quantum wells in a Type I superlattice structure. QCLs emit in the infrared, with QCLs having been demonstrated with emission wavelengths from 2.6 $\mu$m up to 250 $\mu$m.

Ring waveguide in the context of the invention includes not only circular rings but also other suitable closed loop shapes without any tight bends, such as ellipses or ovals, that are capable of supporting whispering gallery modes.

A whispering gallery mode (WGM) in a ring waveguide formed in a semiconductor heterostructure is a mode that propagates circumferentially or azimuthally around the ring waveguide by scattering from the radially outside interface of the ring waveguide, where the scattering may be considered as total internal reflection in ray optics terms. A series of discrete WGMs establishes according to those wavelengths that have phase coherence after a full circulation of the ring according to the formula:

$$\lambda_q = \frac{p \cdot n_{eff}}{q}$$

where $\lambda_q$ is the resonant wavelength, $p$ is the perimeter (or circumference) of the ring, $n_{eff}$ is the effective refractive index of the ring waveguide at the relevant wavelength and q is an integer. A WGM suffers losses from intrinsic loss of the waveguide material and from scattering losses at the radially outside interface of the ring waveguide.

Ring waveguide and disk QCLs based on WGMs are known in the literature.

Early work investigated microdisk lasers for low threshold and single mode operation. Microdisk lasers with diameters below 125 $\mu$m at emission wavelengths at 5 $\mu$m [Ref. 1] and at 9.5 to 11.5 $\mu$m [Ref. 2] were demonstrated at cryogenic temperatures. Ring cavity surface emitting quantum cascade lasers operating in single mode and in pulsed mode up to 380 K were reported in 2010 [Refs. 3, 4]. For the surface emission and for single mode operation, DFB gratings were employed. The ring diameter was 400 $\mu$m. Continuous wave (CW) operation was observed up to 230 K. Since these structures were of the ridge waveguide type, i.e. not buried the cw operation remains challenging. Other challenges are the dense integration and the non-optimal far-field. Room temperature CW operation was achieved with substrate emitting buried heterostructure rings of 800 $\mu$m diameter [Refs. 5, 6]. Thereby, the lasers were mounted epi-layer down. A drawback of the buried heterostructure WGM resonators is that they are limited to rather large radii due to the small refractive index contrast. Recently, another approach demonstrated edge emitting CW operation up to 5°C at an emission wavelength of 8 $\mu$m [Ref. 7]. The outer circumference of an elliptic disk was dryetched and coated with $SiO_2$. The top InP cladding of the disk consisted of an conducting elliptic ring where the inner part is insulating to improve the heat dissipation and to reduce the electrical pumping area. The semi-major axis of the disk's ellipse was 96 $\mu$m. It is unclear from the publication whether the device was mounted epilayer up or down. With similar device geometry and epilayer down-mounting lasing in CW operation up to 50°C at an emission wavelength of 4.7 $\mu$m was demonstrated [Ref. 8].

Ring waveguide QCLs can operate single mode without the need for any distributed feedback (DFB) when the ring is sufficiently small that the free spectral range (i.e. mode spacing between adjacent WGM modes) becomes comparable to or larger than the gain bandwidth (determined by the active region layers in the semiconductor heterostructure). For typical QCL emission wavelengths of 2.6 $\mu$m to 20 $\mu$m, single mode operation (without DFB) is expected as ring diameters are reduced to below a certain amount, which is likely to be well below 100 $\mu$m with the precise threshold ring diameter needed for single mode operation depending on the materials choice and other factors. However, room temperature CW operation becomes increasingly difficult as ring diameter decreases, since more and more overheating occurs in the active region layers and also in the layers above the active region layers in the semiconductor stack. Reducing the volume of the gain medium, which is also achieved by reducing the ring diameter, also reduces power consumption and is hence also desirable for batttery-powered operation. There is a demand for battery-powered cascade lasers for low power mid-infrared gas sensors, for example for Internet of Things (IoT) devices. Reducing the ring diameter also reduces the area of the laser, so that the number of lasers that can be fabricated per unit wafer area increases, resulting in reduced unit cost.

## SUMMARY OF THE INVENTION

According to a first aspect of the invention, there is provided a quantum cascade laser configured to emit a laser beam at a lasing wavelength, A , the laser comprising:

a ring waveguide configured to support whispering gallery modes, the ring waveguide being bounded radially outwards by an outside sidewall and vertically upwards and downwards by refractive index differences between horizontally extending semiconductor layers of a semiconductor stack including active region layers;
top and bottom contacts arranged to provide for carrier injection vertically across the active region layers;
a higher order Bragg grating of order two or greater formed around the ring waveguide, or at least around one arcuate portion thereof, and above the active region layers to couple light at the lasing wavelength upwards out of the ring waveguide to form the laser beam; and
a mirror formed on the outside sidewall by a dielectric mirror layer and a metal mirror layer, the mirror being configured to reflect the whispering gallery modes back into the ring waveguide.

In some embodiments, a single channel is used to form the ring. Namely, the outside sidewall of the ring waveguide is the radially inner sidewall of a ring-shaped trench etched in the semiconductor stack. In other embodiments, a mesa is used to form the ring. Namely, the outside sidewall is the outside sidewall of a ring-shaped mesa etched in the semiconductor stack.

In certain embodiments, the ring waveguide is bounded radially inwards by an inside sidewall that is a buried interface that interfaces with a horizontally extending central layer of insulating semiconductor material to confine the carrier injection to taking place vertically across the active region layers.

In certain embodiments, the ring waveguide includes exposed and buried arcuate portions, there being at least one of each, the exposed arcuate portions forming windows for coupling out laser light scattered by the higher order Bragg grating and the buried arcuate portions being buried by electrically conductive material and acting as the top contact for current injection. In certain embodiments, there is only one exposed arcuate portion. In other embodiments, there are two or more exposed arcuate portions (with buried arcuate portions inbetween) which are collectively arranged around the ring waveguide in a circularly symmetric way, thereby to benefit from interference effects and produce a net vertical output beam with a defined cross-section. Alternatively, instead of having one or more buried arcuate portions separating one or more exposed arcuate portions, the ring waveguide can include an exposed ring surface forming a ring-shaped window for coupling out laser light scattered by the higher order Bragg grating. Optionally, the metal mirror layer can extend around the dielectric mirror layer to act as the top contact for current injection.

There are different alternatives for forming the higher order Bragg grating. One option is to form the higher order Bragg grating with radially extending ribs of semiconductor material buried in or between semiconductor layers of the semiconductor stack. This can be termed a buried Bragg grating and is typical of publications from the group of Professor Jerôme Faist at ETH Zürich. Another option, is to form the higher order Bragg grating with radially extending ribs that are etched out of at least one semiconductor layer that lies above the active region layers. This can be termed a corrugated surface Bragg grating and is typical of publications from the group of Professor Gottfried Strasser at TU Wien.

Optionally, a metal heat extraction layer can be formed on the metal mirror layer. The metal mirror layer and the metal heat extraction layer preferably have a joint thickness in the radial direction suitable for providing enough heat extraction to permit CW operation of the laser at room temperature. For good heat extraction, the thickness of metal collectively provided by the (thin) metal mirror layer and the (thick) metal heat extraction layer in the lateral or radial direction is a minimum of one of 0.5, 1.0, 1.5, 2.0, 2,5, 3.0, 4.0, 5.0, 6.0, 7.0 or 8.0 micrometers. Moreover, the thickness should not be too thick, since after a certain thickness the marginal improvement in heat dissipation becomes very small. A maximum thickness in the lateral or radial direction of no more than one of 6, 7, 8, 9, 10, 12, 14, 16, 18 and 20 micrometers is hence preferred.

In embodiments that include a metal heat extraction layer, the metal mirror layer and the metal heat extraction layer can be deposited separately by separate fabrication process steps, so form separate layers, even though they may be made of the same metal. This is convenient, since the metal mirror layer need only be thin (e.g. 100-300 nm) and is generally expensive to fabricate in order to ensure good reflection properties whereas the metal heat extraction layer may need to be much thicker (e.g. several micrometers) and can be fabricated without regard to its reflection properties. However, it is also possible that the metal mirror layer and the metal heat extraction layer are formed integrally as one and the same layer in a single fabrication process step which may be more convenient if the total thickness of metal needed is modest (e.g. one micrometer or less).

Optionally, the mirror may comprise two or more pairs of dielectric-metal layers. Namely, the laser may further comprise one or more additional dielectric and metal mirror layers.

Suitable dielectric materials to use for the dielectric mirror layer and optional additional dielectric mirror layers include: alumina, $Al_2O_3$ and silicon nitride, $Si_3N_4$.

Suitable metals to use for the metal mirror layer and optional additional metal mirror layers include: gold, tin, silver and aluminium. Alloys or mixtures of these metals may also be used.

To form the mirror, in certain embodiments, the dielectric mirror layer and optional additional dielectric mirror layers each have a physical thickness of between 0.2 and 0.3 times one-quarter of the lasing wavelength within the dielectric material of the dielectric layer. The dielectric layer should also not be too thick, since if it is too thick it will become a significant thermal barrier to heat dissipation given that typical dielectric materials are relatively poor thermal conductors compared to metals. Specifically, the dielectric layer preferably has a thickness of no more than 1000 nanometres. A certain minimum thickness is however needed to provide good reflection properties (with the metal mirror layer) and to avoid pinholes that could result in electrical shorts. For example, the dielectric mirror layer has a thickness of at least one of 30 nm, 50 nm, 70 nm or 100 nm and/or less than or equal to one of 500 nm, 600 nm, 700 nm, 800 nm, 900 nm or 1000 nm.

Ring waveguide width is also a significant parameter. Specifically, the waveguide width may beneficially be at least $\lambda/n_{eff}$, where $n_{eff}$ is the effective refractive index of the ring waveguide at the lasing wavelength. Moreover, making the waveguide width overly wide does not improve performance while causing increased power consumption through increasing the area and hence volume of the gain medium. For example, the waveguide width can be given an upper limit of a small multiple of $\lambda/n_{eff}$ such as 1.5, 2.0, 2.5 or 3.0. Specific example waveguide widths are in the range 1 to 12 $\mu$m. The waveguide width is a minimum of one of 1.0, 1.5, 2.0, 2.5, 3.0, 3.5 and 4.0 micrometers and/or a maximum of one of 1.5, 2, 3, 4, 5, 6, 7, 8, 9, 10, 11 and 12 micrometers.

For single mode operation of the laser without the need for distributed feedback structures, the circumference of the ring should be small enough so that the mode separation between adjacent whispering gallery modes is comparable to the gain bandwidth. Namely, the active region layers form a gain medium having a range of wavelengths over which gain is possible, referred to as the gain bandwidth and the ring waveguide has a circumference that defines the wavelength separation between adjacent whispering gallery modes. For single mode operation a convenient range of mode separation and gain bandwidth is when the mode separation is between 0.2 and 0.8 times the gain bandwidth.

It will be appreciated that even in single mode operation there will be some small amount of mode power in other modes. A suitable quantative definition for single mode operation is therefore as follows: When operating in single mode at an optical output power of one of 0.5 mW and 1 mW, the QCL has a side-mode suppression ratio of greater than 30 decibels.

We envisage typical ring waveguide circumferences for most embodiments where the minimum is one of 20, 30, 40 or 50 $\mu$m and the maximum is one of 200, 300, 400, 500, 600 and 700 $\mu$m as measured geometrically around the outside sidewall.

According to a second aspect of the invention, there is provided a method of manufacturing a quantum cascade laser configured to emit a laser beam at a lasing wavelength, A, the method comprising:

    providing a semiconductor substrate;
    forming a semiconductor stack by:

        depositing a lower cladding layer;
        depositing a sequence of active region layers; and
        depositing an upper cladding layer;

    etching into the semiconductor stack at least as far as through the active region layers to define an outside sidewall and an inside sidewall for a ring waveguide capable of supporting whispering gallery modes;
    forming a higher order Bragg grating of order two or greater around the ring waveguide, or at least around one arcuate portion thereof, and above the active region layers to couple light at the lasing wavelength upwards out of the ring waveguide to form the laser beam;
    forming top and bottom contacts to provide for carrier injection vertically across the active region layers;
    depositing a dielectric layer on the outside sidewall; and
    depositing a metal layer on the dielectric layer, the metal layer and the dielectric layer together forming a mirror configured to reflect whispering gallery modes supported by the ring waveguide.

The method may further comprise: depositing a metal heat extraction layer on the metal mirror layer, wherein the metal mirror layer. The metal heat extraction layer may have for example a joint thickness in the radial direction of at least 0.5 micrometres.

The method may further comprise: depositing by overgrowth a central layer of insulating semiconductor material to bury the inside sidewall and thereby form a buried interface between the ring waveguide and the central layer, the central layer serving to confine carrier injection to vertically across the active region layers.

In some embodiments, the etching to define the outside sidewall involves etching a ring-shaped trench, the radially inner trench sidewall defining the outside sidewall of the ring waveguide. In other embodiments, the etching to define the outside sidewall of the ring waveguide involves etching a ring-shaped mesa, so that a height portion of the mesa sidewall forms the outside sidewall of the ring waveguide.

In embodiments that include a metal heat extraction layer ,the metal mirror layer may be deposited through evaporation and the metal heat extraction layer is deposited by electroplating. Alternatively, the metal mirror layer and the metal heat extraction layer may be deposited together by the same deposition process.

A further aspect of the invention relates to an array of multiple quantum cascade lasers according to the first aspect of the invention formed monolithically on a single chip.

A still further aspect of the invention relates to a sensor device comprising one or more quantum cascade lasers according to the first aspect of the invention in combination with one or more infrared detectors arranged to receive light emitted from the quantum cascade laser or quantum cascade lasers after scattering from a gas species to be sensed.

## BRIEF DESCRIPTION OF THE DRAWINGS

This invention will now be further described, by way of example only, with reference to the accompanying drawings.

Figure 1A is a schematic plan view of a ring quantum cascade laser according to a first embodiment of the invention.

Figures 1B and 1C are cross-sections of the ring quantum cascade laser of Figure 1A through respectively the radial line 1B and the arcuate line 1C shown in Figure 1A.

Figure 1D is a cross-section of the ring quantum cascade laser of Figure 1A through radial line 1D shown in Figure 1A.

Figure 1E shows a variant of the first embodiment by way of an altered detail of the area shown by the dashed rectangular box in Figure 1B.

Figure 2 is a schematic section view of a ring quantum cascade laser according to a second embodiment of the invention, where the section corresponds to that of Figure 1B of the first embodiment.

Figure 3 is a schematic section view of a ring quantum cascade laser according to a variant of the first embodiment of the invention, where the section corresponds to that of Figure 1C of the first embodiment.

Figure 4 is a schematic section view of a ring quantum cascade laser according to a further variant of the first embodiment of the invention, where the section corresponds to that of Figure 1B of the first embodiment.

Figures 5A to 5C are scanning electron microscopy (SEM) images of example QCLs.

Figures 6A to 6D show different structures used for thermal simulations.

Figure 7A to 7D are graphs of thermal simulation results plotting maximum CW operating temperature as a function of ring diameter for each of the structures of Figures 6A to 6D.

Figure 8 is a schematic drawing of an example gas sensor based on laser absorption spectroscopy in a linear, transmission configuration.

Figure 9 is a schematic drawing of an example gas sensor based on laser absorption spectroscopy with the laser emitter and detectors in a planar, reflection configuration.

Figure 10 is a schematic drawing of an example gas sensor based on photoacoustic spectroscopy with the laser emitter and the acoustic detector in a planar configuration.

## DETAILED DESCRIPTION

In this document, reference to specific numerical values, for example as range end points, are to be taken as exact values and are not to be rounded whether that be by significant figures, number of decimal places or otherwise.

As mentioned further above, the term ring waveguide in the context of the invention includes not only circular rings but also other suitable closed loop shapes without any tight bends, such as ellipses,ovals or limaçons, that are capable of supporting whispering gallery modes. However, for linguistic simplicity, the drawings show and the following detailed description refers solely to circular rings, which allows the use of useful descriptive terms such as diameter etc. When specific values for ring diameter are stated, for convenience of measurement in a real structure these refer to the outside diameter of the ring (labelled $d_o$ in the drawings) rather than the optical axis within the waveguide. In a cylindrical coordinate system the diameter of the optical axis can be expressed as

$$d_{opt} = 2 \cdot r_{opt} = 2 \frac{\iint r \, S_\varphi(r, \varphi = 0, z) \, dA}{\iint S_\varphi(r, \varphi = 0, z) \, dA},$$

where r is the radial distance from the z-axis to the center of the ring, $\varphi$ is the azimuth and z the height of the ring. The energy flux in the azimuthal direction is integrated over half of the ring cross-section in the rz - plane.. It will be also be understood that, since the circumference of a circle is $\pi d_{opt}$, when a specific value for the ring diameter is stated, this is equivalent to a circumference of a non-circular ring of $\pi d_{opt}$.

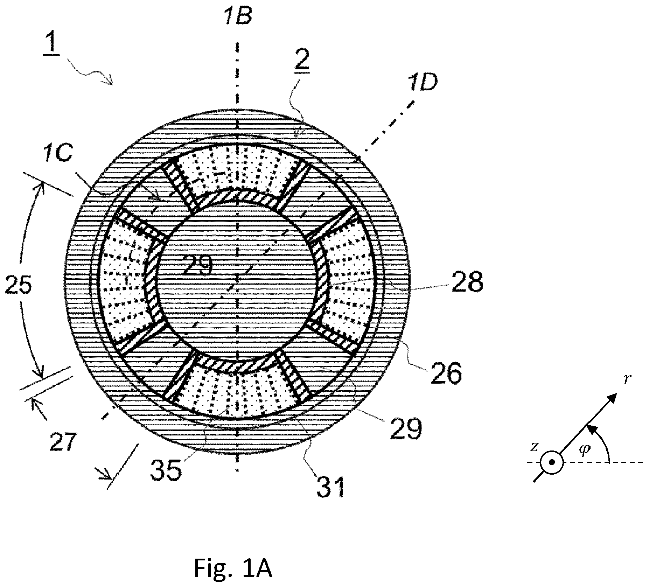

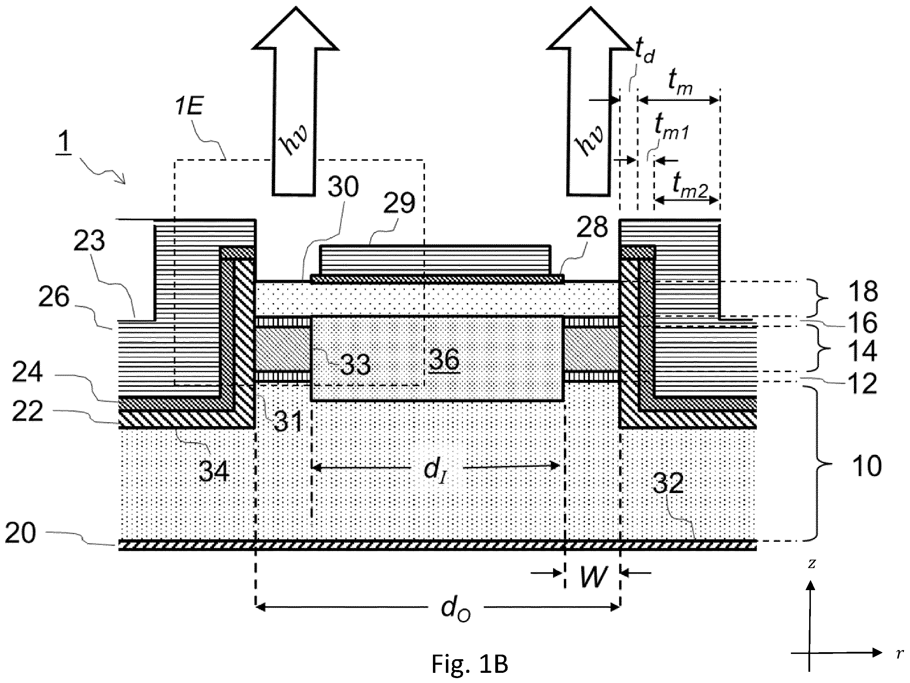

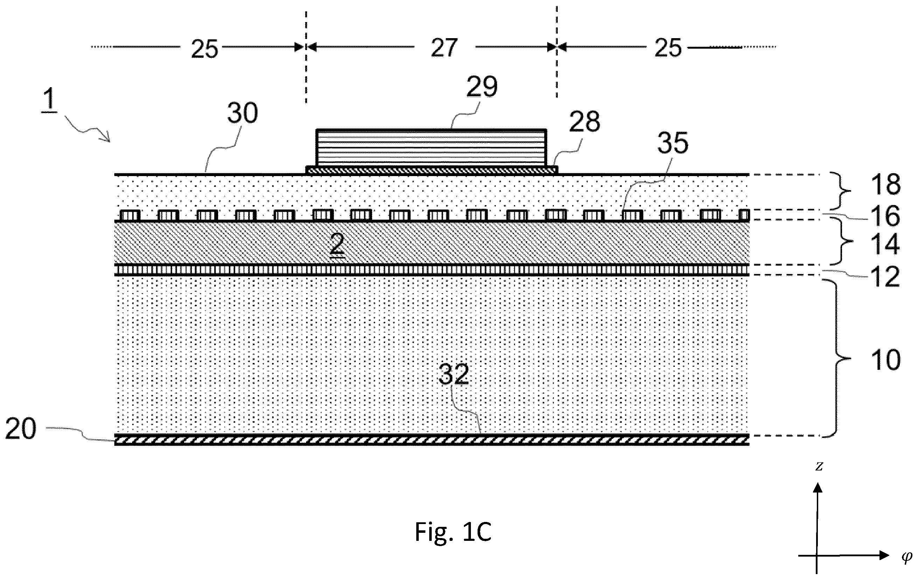

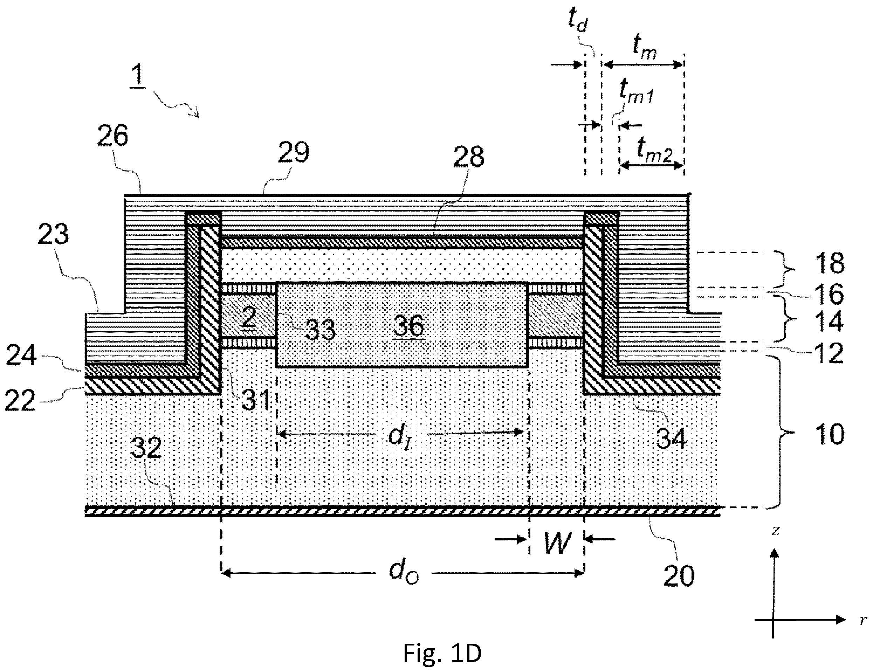

Figures 1A to 1D are different view of a ring QCL 1 according to a first embodiment of the invention. The ring QCL 1 is based around a ring waveguide 2. Figure 1A is a schematic plan view. Figure 1A also shows the sections used for Figures 1B, 1C and 1D, these being indicated with chain-dotted lines and corresponding labels. In the following text, we refer to suitable specific example materials in curved brackets after referring to specific layers or other features.

Referring initially to Figure 1A, although the same features are also visible in Figures 1B to 1D, a higher order Bragg grating 35 serves as an extractor element for coupling light at the lasing wavelength out of the top surface of the ring waveguide 2 to form the output laser beam. By higher order we mean an order two or greater. The higher order Bragg grating 35 is formed in one or more segments around respective exposed arcuate portions 25 of the ring waveguide 2. Four such Bragg grating segments and exposed arcuate portions 25 are illustrated by way of example, these being disposed in a circularly symmetric way around the ring. Other numbers of Bragg grating segments are possible, including one. Preferably the Bragg grating segments are disposed in a circularly symmetric way around the ring so that a vertically travelling output beam is formed by interference between the beam portions emitted from the different Bragg grating segments. The higher order Bragg grating 35 is formed above the active region layers and couple out laser light upwards out of the laser 1.

The exposed arcuate portions 25 have buried arcuate portions 27 in between. The buried arcuate portions are buried by electrically conductive material (Au) which are radial extension tabs of the top layer of a top contact 29 for current injection across the areas of the active region layers 14 (not visible in Figure 1A) that lie under the buried arcuate portions 27. The function on the exposed arcuate portions 25 is to provide windows for output of the output beam portions from the respective Bragg grating segments.

Figure 1B is a cross-section of the ring cascade laser of Figure 1A through the radial line 1B shown in Figure 1A which goes through one of the windows for outcoupling the laser beam where the top of the semiconductor stack is exposed, i.e. one of the exposed arcuate portions 25. The semiconductor stack of heterostructure layers arranged on a substrate 10 (n:InP) which also acts as lower outer cladding layer. Alternatively, a separate lower outer cladding layer could be deposited as part of the semiconductor stack. The semiconductor stack comprises in sequence from bottom to top:

- an inner lower cladding layer 12 (n:InGaAs);
- active region layers 14 (MQW structure of InGaAs/AlInAs);
- an inner upper cladding layer 16 (n:InGaAs); and
- an outer upper cladding layer 18 (n:InP).

The semiconductor stack thus terminates with the bottom surface 32 of the substrate 10 and the top surface of the uppermost semiconductor layer, which in this case is the outer upper cladding layer 18. The semiconductor stack is processed to form the ring waveguide 2 by etching a ring-shaped depression, i.e. a cylindrical pit, through the layers 16, 14 and 12 and partly into the substrate 10 and then regrowing into the depression an insulating semiconductor layer 36 (InP:Fe). The insulating semiconductor layer 36 is thus a central layer formed by overgrowth after selective etching away of a radially inner portion of the active region layers.The outer cylindrical surface of the insulating semiconductor layer 36 forms a buried interface with the semiconductor stack layers 12, 14, 16 that defines the inside sidewall 33 of the ring waveguide 2. When considered in a horizontal section (i.e. in the plane of the layer) through the active region layers, the overgrown insulating semiconductor layer 36 is an island of diameter $d_I$ inside the ring waveguide 2 with the outline of the ring waveguide's inside sidewall 33. The principal function of the insulating semiconductor layer 36 in the middle of the ring waveguide 2 is to inhibit current injection across the middle of the ring so that carrier injection is restricted to taking place vertically across the active region layers 14. This avoids unnnecessary electrical power consumption, which is important for battery-powered operation, and also unnecessary heating, which would be detrimental to achieving the aim of CW operation at room temperature. An optional secondary function is to aid radial confinement at the buried interface by the insulating semiconductor layer 36 having a refractive index that is lower that of the active region layers 14. The reason that a refractive index drop at the inside sidewall 33 is not essential for the ring waveguide 2 is that lasing of the device is based on WGMs and the nature of such modes is that, provided the waveguide width is not too small, the WGMs are essentially confined to close to the outside sidewall 31 and have only negligible strength at the inside sidewall 33. On the other hand, when the waveguide width is small, perhaps below about $\lambda / n_{eff}$, the insulating semiconductor layer 36 should have a lower refractive index than the active region layers. The ring waveguide 2 is thus bounded radially outwards by an outside sidewall 31 and vertically upwards and downwards by refractive index differences between horizontally extending semiconductor layers of the semiconductor stack, namely by the active region layers 14 being sandwiched between the cladding layers 10/12, 16/18.

A ring-shaped mesa structure of diameter $d_O$ is then formed by etching into the semiconductor stack. The cylindrical sidewall 31 of the mesa structure defines the outside sidewall 31 of the waveguide 2. The etching takes place at least as far as through the active region layers 14 and some way into the substrate 10 (or alternatively separate outer cladding layer - not shown). After etching the mesa, the top surface of the semiconductor stack outside the mesa is thus at the level of the substrate 10 and is labelled 34 in the drawings. The outside sidewall 31 formed by the mesa structure and the inside sidewall 33 formed by the insulating semiconductor layer 36 define the width $W$ of the ring waveguide 2, where $W = d_O - d_I$.

Top and bottom contacts are then deposited to provide for carrier injection vertically across the active region layers 14. The top contact is formed first by depositing a top contact layer 28 (metallization; Ti, Pt, Au or alloy therebetween) on the outer upper cladding layer 18 and then by depositing a thicker metal layer (electroplated Au) which not only has the electrical function of providing a part of the top contact but also has a thermal function to provide for heat extraction of the heat generated in the ring waveguide 2 by the lasing action. The contact layer 28 between the top of the semiconductor stack 30 and the electroplated thicker metal layer 29 is provided for good adhesion and materials' compatibility. The bottom (or base) contact 20 (metallization; Ge/Au/Ni/Au) is formed on the bottom surface 32 of the substrate 10.

The mesa's outside sidewall 31 is then coated with a dielectric layer 22 ($Si_3N_4$ or $Al_2O_3$) of thickness $t_d$. A metal layer 24 (metallization; Ti/Au or alloy therebetween) of thickness $t_{m1}$ is then coated on the dielectric layer 22. The dielectric and metal layers 22 and 24 together form a mirror to reflect whispering gallery modes formed in the ring waveguide 2 from the outside sidewall 31 back into the ring waveguide 2. Alternative materials for the dielectric sidewall coating are $SiO_2$, $Al_2O_3$ and MgO. A further metal layer 26 (electroplated Au) of thickness $t_{m2}$ is then formed on the metal layer 24 for heat extraction out of the side of the ring waveguide. The metal layers 24, 26 thus form a composite block of metal with a joint thickness in the radial direction of $t_m = t_{m1} + t_{m2}$ which should be large enough to provide the desired amount of heat dissipation. The outer metal layer 26 will in most cases be much thicker than the inner metal layer 24, i.e. $t_{m1} \ll t_{m2}$. It is noted that the metal layer 24 will typically have a thickness that exceeds the skin depth of the light (skin depth is typically < 30 nm) by several times, so the outer metal layer 26 will play no role in reflecting the WGMs, i.e. is functionally not part of the mirror.

In a variant (not illustrated), the dielectric-metal mirror layers 22, 24 shown in Figure 1B may be repeated before depositing the thick metal layer 26. Namely, compared with Figure 1B, there may be one or more additional pairs of dielectric and metal layers 22, 24 arranged between the thin metal layer 24 the thick electroplated metal layer 26. A dielectric-metal mirror of this kind is capable of providing extremely high reflectivity. In particular, when there are multiple pairs of dielectric and metal layers 22, 24, they can be provided with suitable thicknesses for satisfying (or at least approximately so) the Bragg condition. Classically, the Bragg condition is met when the layer thicknesses of the two different materials forming the Bragg grating are both $\lambda/4$, where the physical thicknesses of the layers of the two materials will differ as a result of their different refractive indices. However, modelling shows that close compliance with the Bragg condition is not necessary in the proposed structures for high reflectivity. To comply with the Bragg condition, the buried dielectric layer and optional additional buried dielectric layers each have a physical thickness of between 0.2 and 0.3 times one-quarter of the lasing wavelength within the dielectric material of the dielectric layer. In other words, the dielectric layer or layers each have a physical thickness of 0.2 to $0.3 \cdot \lambda/(4 \cdot n_d)$, where $n_d$ is the refractive index of the dielectric material at the lasing wavelength $\lambda$. The same applies to the additional thin metal layers formed between the dielectric layers to form the periodic layered structure.

Although the above-described multiperiod dielectric-metal mirrors are possible within the scope of the invention, it is an important advantage of the proposed ring waveguide structures based on lasing of WGMs that the mirror does not need to have extremely high reflectivity. This is a significant difference from a comparable linear cavity cascade laser design which will require end mirrors with extremely high reflectivity (e.g. R>98%) in order to build lasers shorter than 100 $\mu$m. By comparison, in the proposed WGM-based ring waveguide cascade laser, the mirror on the outside sidewall of the ring waveguide is only serving to reduce what are in any case relatively small scattering losses of light out of the ring owing to the relatively small mode overlap with the low refractive index dielectric layer. However, the use of a single dielectric layer followed by a single metal layer to form the mirror will provide a sufficiently high reflectivity in most cases.

Figure 1C is a cross-section of the ring cascade laser of Figure 1A through arcuate line 1C shown in Figure 1A, i.e. along the centre of the waveguide 2. The length of the section encompasses one of the radial extension tabs of the top contact 29, i.e. one of the buried arcuate portions 27 shown in Figure 1A, as well as portions of the two adjacent exposed arcuate portions 25. The higher order Bragg grating is formed by radially extending ribs of semiconductor material buried in or between semiconductor layers of the semiconductor stack following the general approach of Prof. Jerôme Faist and co-workers at ETH Zurich. The Bragg grating is illustrated as extending around the whole circumference of the ring. An alternative is to omit grating ribs under the buried arcuate ring portions 27, so that the Bragg grating is formed only over the exposed arcuate ring portions 25.

Figure 1D is a cross-section of the ring cascade laser of Figure 1A through radial line 1D shown in Figure 1A, which goes through one of the buried arcuate portions 27 where metal covers the top of the mesa. As can be seen, the metal layer 29 is a continuous block in which the radial extension tab part of the metal layer 29 is congruent with the thick metal layer 26 attached to the outside sidewall 31 of the mesa. This provides a path for thermal conduction from the thick metal layer 26 to the metal layer 29 and beyond through the contact wires, thereby aiding heat dissipation from the thick metal layer 26 through the path of the metal layer 29 which supplements the heat sink effect of the thick metal layer 26 which can also dissipate heat sideways to the air (or other gas used in the packaging).

While it has been implied that electrical contact with bond wires or probes will be directly to the top surface of the metal layer 29 this is not the case for all embodiments. As the ring outside diameter $d_O$ reduces, the diameter of the metal layer 29 reduces too and it becomes increasingly difficult to implement direct bonding to it. Direct bonding using wire bonds becomes difficult at outside diameters below about 100 $\mu$m. To solve this problem, the bonding can be done indirectly to the metal layer 26 by extending the metal layer 26 radially outwards by a sufficient amount to form a lateral extension 23 to form a suitable surface for bonding a wire to. An electrical path is provided by the buried arcuate portions 26 which bridge between the metal layers 26 and 29 (as shown in plan view in Figure 1A and in the section along line 1D as shown in Figure 1D). These bridges provide linking metal between the electroplated layer 26 and the metal layer 29. The surface of the lateral extension 23 of the metal layer 26 is then used as a lithographically defined bond pad. It is noted that the top electroplated layer 29 is not crucial (as already stated in the document) and could be omitted.

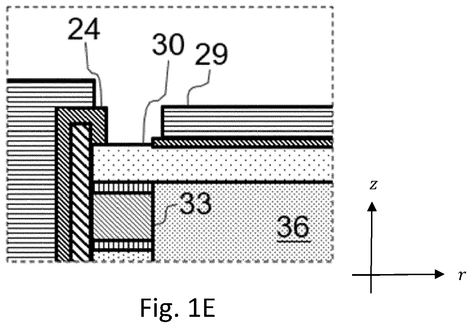

Figure 1E is a cross-section of a modification of the design of Figure 1B showing only the portion marked with the rectangular box '1E' of Figure 1B. The other parts of the cross-section are the same as in Figure 1B. As illustrated, a metal bridge for current injection is formed by extending the metal layer 24 around the dielectric layer 22 so that the metal layer 24 comes into contact with the top surface 30 of the upper cladding layer 18 as illustrated so that the mirror metallization layer 24 terminates on the top surface 30 of the outer upper cladding layer 18. The doping concentration of the cladding layer 18 can be increased towards the surface 30 to ensure a good electrical contact at the semiconductor/metal interface. This approach is an alternative way of providing metal to bridge across from outside to inside the ring and thereby allow wire bonding to the metal layer 26 as may be required for small diameter rings. This approach can be followed for embodiments in which the ring is completely open, i.e. there are no buried arcuate portions 27. Namely, to form an open ring, the ring cascade laser of Figure 1A/1B is modified so that the exposed arcuate portion 25 extends around the whole ring and there is no buried arcuate portion 27.

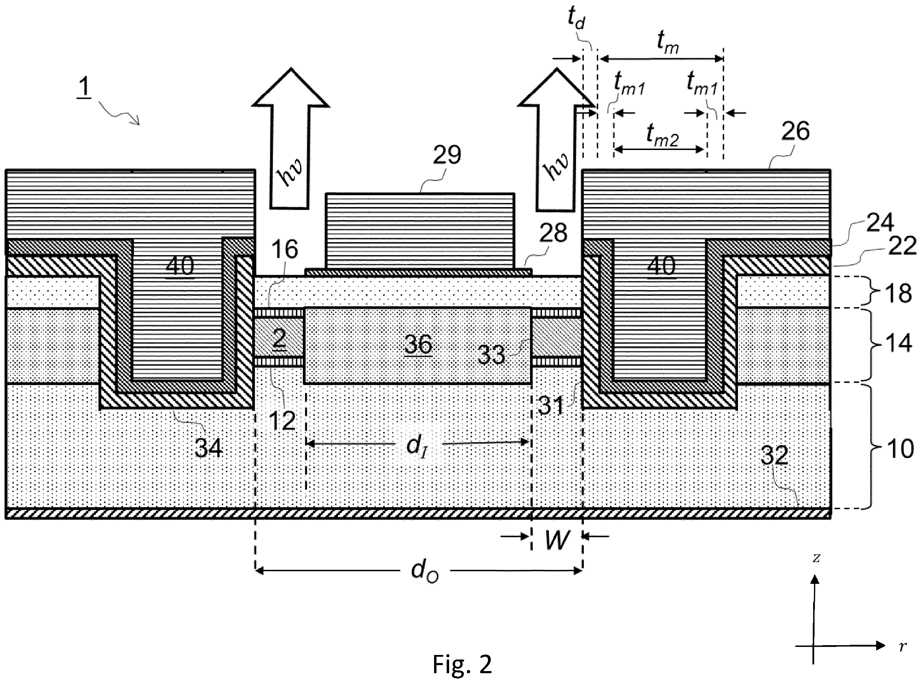

Figure 2 is a schematic section view of a ring QCL according to a second embodiment of the invention. The section corresponds to that of Figure 1B for the first embodiment. Corresponding reference numerals and other labels are also used. The principal difference between the first and second embodiments is that in the second embodiment, instead of a mesa, the outside sidewall of the ring waveguide is formed by a trench 40 formed by etching a single channel in a ring shape. The etch depth of the trench 40 corresponds to the etch depth of the mesa in the first embodiment, the trench 40 having a base surface 34 and an inside sidewall 31 that forms the outside sidewall of the ring waveguide 2. The thick metal layer 26 is deposited to fill the trench 40 as well as providing a certain thickness of metal above the top of the trench on the top surface 30 of the semiconductor stack, which here is the top surface of the outer upper cladding layer 18. The width of the trench-forming channel thus defines the maximum possible metal layer thickness $t_m$. The metal layer thickness $t_m$. may however be less than the trench width. Although not visible in the section of Figure 2, with reference to Figure 1D for the first embodiment, the metal layer 29 is a continuous block in which the radial extension tab part of the metal layer 29 is congruent with the thick metal layer 26 that fills the trench 40 and thus is adjacent to the outside sidewall 31 of the waveguide 2. It is noted that a similar approach to indirect connection of bonding wires via layer 26 as described above for the first embodiment can be used also in the second embodiment using an area on the surface of the metal layer 26 that is radially outside the trench 40.

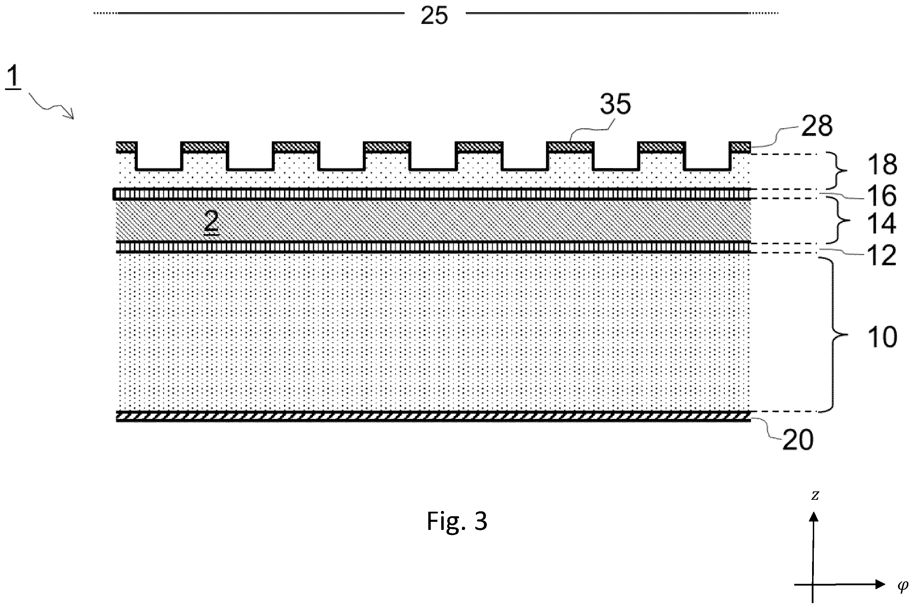

Figure 3 is a schematic section view of a ring QCL laser according to a variant of the first embodiment of the invention, where the section corresponds to that of Figure 1C of the first embodiment. The difference relates to how the higher order Bragg grating 35 is fabricated. In the first embodiment, the Bragg grating was a buried one following the usual approach of Prof. Jerôme Faist and co-workers at ETH Zurich. In the variant, the Bragg grating is fabricated as a corrugated surface structure following the usual approach of Prof. Gottfried Strasser and co-workers at TU Wien. The length of the section encompasses only a portion of one of the exposed arcuate portions 25. In the buried arcuate portions 27 (not shown) the metal coverage of layers 28 can continue so that the surface corrugations exist all the way round the ring. Alternatively, the surface corrugations could be omitted in the buried arcuate portions 27. The surface corrugations are formed by etching through the metal layers 28 part way into the top layer of the semiconductor stack, here the outer upper cladding layer 18, so that the higher order Bragg grating is formed by radially extending ribs etched out of a top part of the semiconductor stack lying above the active region layers 14.

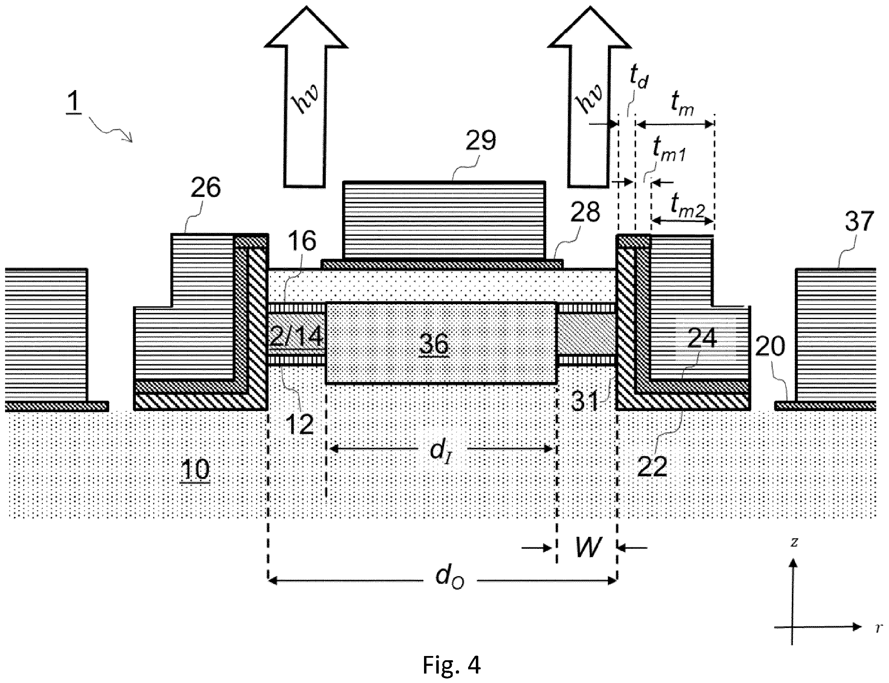

Figure 4 is a schematic section view of a ring QCL according to a further variant of the first embodiment of the invention, where the section corresponds to that of Figure 1B of the first embodiment. The difference relates to how the base contact is formed. Instead of forming the base contact 20 on the bottom surface 32 of the substrate 10, the base contact 20 is instead formed on the etched top surface 34 of the semiconductor stack at the base of the mesa. The base contact includes in addition to the base contact layer 20 (metallization; Ge/Au/Ni/Au) also a thicker metal layer 37 on top (electroplated Au) which can be deposited in the same process step as the other electroplated metal layers 26, 29. Since the etched top surface 34 lies below the level of the active region layers 14, the desired vertical current path through the active region layers 14 is still provided by the top and bottom contact pair.

The thicknesses of the dielectric layer 22 on the side surface 31 of the mesa in the first and third embodiments or inner trench wall in the second embodiment and the combined thickness of the metal layers 24, 26 on the dielectric layer 22 (as well as any optional additional pairs of layers 22, 24 for forming a Bragg mirror) are key parameters to provide for good heat dissipation from the active region layers and hence achieve room temperature CW operation.

We have performed thermal simulations which show that as the diameter of the ring waveguide is reduced there is insufficient heat dissipation from the top of the semiconductor stack. The ring waveguide heats up and CW operation at room temperature is no longer possible. To solve this problem caused by reducing the ring diameter, we form the outside of the ring waveguide on an exposed wall, either a cylindrical mesa sidewall or inner wall of a trench-forming ring-shaped channel, and cover the exposed wall with a thick layer of metal of thickness $t_m$. For CW operation at room temperature, the thickness of the metal that is needed on the exposed outside sidewall of the ring waveguide will vary depending on the ring diameter, choice of materials and other factors. According to our simulations of some specific examples, a thickness of at least 3 $\mu$m provides for good heat extraction taking account of the thermal conductivity values of metals that are used. The improvement in heat dissipation seen in our simulations as the metal layer thickness is incrementally increased from 1 to 2 to 3 $\mu$m is very large. The optimum metal layer thickness according to our simulations lies in the range 3 to 10 $\mu$m for most typical QCL structures with the best compromise between heat dissipation and metal layer thickness being at thicknesses of about 5 to 6 $\mu$m. The reason for specifying an upper limit on the metal layer thickness is simply because the incremental improvement of heat dissipation for each extra amount of metal layer thickness gradually reduces at larger thicknesses eventually becoming insignificant at some thickness. According to our simulations, increasing the thickness of metal on the exposed side of the mesa, i.e. the outside sidewall of the ring waveguide, beyond about 10 $\mu$m is seldom worthwhile. The outside metal layer may have a thickness of at least one of 0.5, 1.0, 1.5, 2.0, 3.0, 4.0, 5.0, 6.0, 7.0 or 8.0 $\mu$m and/or no more than one of 6, 7, 8, 9, 10, 12, 14, 16, 18 and 20 $\mu$m. The simulations also show that the metal thickness needed on the exposed outside sidewall of the ring waveguide to provide a given amount of heat dissipation increases as ring diameter reduces. For example, to provide the same heat dissipation as a metal layer of thickness of 3 $\mu$m at a ring diameter of 200 $\mu$m, 4 $\mu$m are needed at a ring diameter of 100 $\mu$m and 5 $\mu$m at a ring diameter of 50 $\mu$m.

The dielectric layer thickness $t_d$ is also significant, since the dielectric material has a relatively low thermal conductivity, so the dielectric layer 22 needs to be sufficiently thin that it does not have a limiting effect on the heat transfer from the hot waveguide 2 to the thick metal layer 24, 26. The heat dissipation is not significantly inhibited at the typical dielectric layer thickness that are used to provide good mirror reflectivity in the near infrared but may become more important at longer laser emission wavelengths and/or if the dielectric layer is part of a periodic stack of metal-dielectric layers used to form a Bragg mirror at the Bragg condition. With $Si_3N_4$ as the dielectric material and without any additional pairs of metal-dielectric layers our simulations shown that dielectric layer thickness in the range 100-300 nm provide good reflectivity for the mirror while at the same time not impacting significantly on the heat dissipation radially outwards via the metal layer 26. The same simulations show that increasing the $Si_3N_4$ thickness beyond about 1 $\mu$m starts significantly impacting on the lateral heat dissipation especially at smaller ring diameters less than 100 $\mu$m. In certain embodiments, the buried dielectric layer has a thickness of no more than 1000 nanometres. The buried dielectric layer may have a thickness of at least one of 30 nm, 50 nm, 70 nm or 100 nm and/or less than or equal to one of 500 nm, 600 nm, 700 nm, 800 nm, 900 nm or 1000 nm. The lower end of the dielectric layer thickness range is determined by the thickness that is needed to provide good electrical insulation betwen the metal layer 24, 26 and the ring waveguide 2, which is needed to avoid electrical problems with the carrier injection.

Another significant parameter is the width W of the ring waveguide 2. For ring diameters in the range 10 to 200 $\mu$m (i.e. circumferences of about 30 to 600 $\mu$m), suitable waveguide

include widths in the range 3 to 10 $\mu$m. Since the volume of heated semiconductor material where current injection is taking place reduces with decreasing waveguide width, the maximum CW operating temperature of the laser also increases with decreasing waveguide width, since there is less heat to dissipate. For example, in our simulations we see that the maximum CW operating temperature increases from about 0°C to 70°C when waveguide width is reduced

from 8 $\mu$m to 3 $\mu$m in an example structure with an emission wavelength of 8 $\mu$m and a ring diameter of 200 $\mu$m. There is however a limit to the benefit of reducing waveguide width, since as shown by electromagnetic simulations we performed, the threshold current density becomes undesirably large below a certain waveguide width, which was about 3 $\mu$m or 4 $\mu$m for the range of different structures and emission wavelengths that we modelled. According to these simulations, the best compromise between the competing factors of low threshold current and high maximum CW operating temperature is achieved at waveguide widths in the range 4 $\mu$m to 6 $\mu$m or perhaps 4 $\mu$m to 8 $\mu$m. More generally, optimum waveguide widths are in the range defined by a lower limit which avoids any significant WGM mode power at the buried inside sidewall of the waveguide, e.g. $\lambda/n_{eff}$ as discussed further above, and an upper limit defined by extra width that has no functional effect and merely serves to consume extra power when the QCL is in operation, e.g. 1.5 or 2 times $\lambda/n_{eff}$.

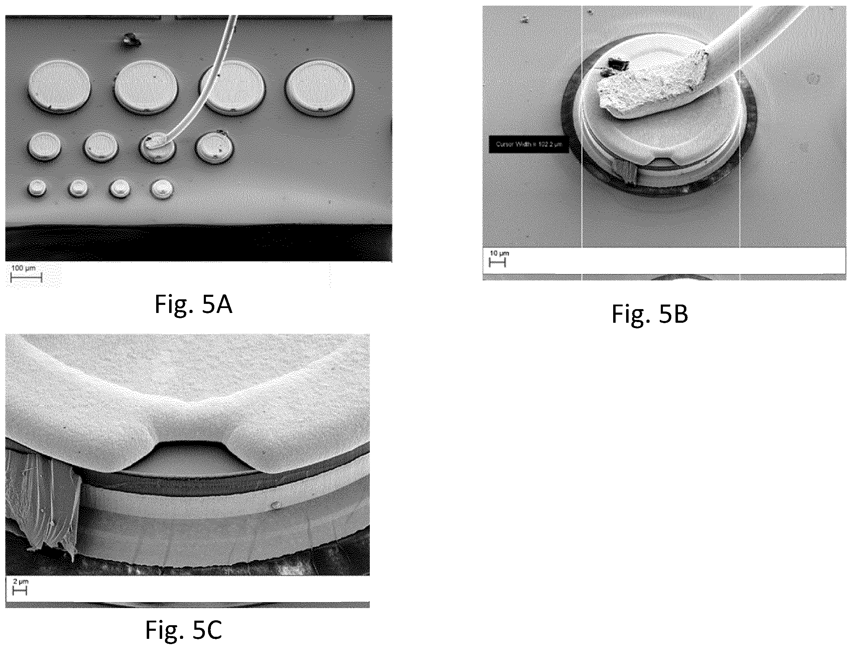

Figures 5A-5C are scanning electron microscopy (SEM) images of example QCLs we have fabricated. The SEM images include a label for scale and the timestamp. Figure 5A shows three rows of QCLs fabricated on the same wafer. The top row of QCLs have a ring diameter of 200 $\mu$m, the middle row 100 $\mu$m and the bottom row 50 $\mu$m. The QCLs in each row have different waveguide widths, namely 3 $\mu$m, 4.5 $\mu$m, 6 $\mu$m, 7.5 $\mu$m. Figures 5B and 5C are successively higher magnification images of the contacted QCL of Figure 5A. It can be seen that the QCL has a single exposed arcuate portions (reference number 25 in the schematic drawings) where a buried Bragg grating (of the Faist group type) outcouples laser light upwards out of the structure.

After growth of the layers of the heterostructure, the illustrated QCLs were fabricated by the following process steps:

1. Forming the grating 35 by etching into the upper inner cladding 16 and then regrowing a thin InP planarization layer regrowth -500 nm

2. Etching the rings 2 with an outer diameter larger than $d_O$

3. Regrowth of insulating material to form layer 36

4. Regrowth of top cladding layer 18

5. Depositing Ti/Pt/Au to form top contact layer 28

6. Dry-etching mesa to form outside sidewall 31 with diameter $d_O$

7. Coating to deposit dielectric mirror layer 22

8. Coating to deposit gold mirror layer 24

9. Etching the top buried metallic contact to form surface outcoupling window 25

10. Electroplating thick metal on top of structure, i.e. layer 29

11. Thinning the backside of the substrate 10 and depositing gold ohmic back contact 20.

Suitable techniques for depositing the dielectric material for the dielectric mirror layer 22 include: plasma-enhanced chemical vapour deposition (PECVD), electron-beam evaporation or atomic layer deposition (ALD), materials $SiO_2$, $Si_3N_4$ and $Al_2O_3$.

A suitable technique for depositing the metal for the metallic mirror layer 24 is electron-beam evaporation, wherein the sample is tilted during the deposition to cover the etched sidewalls of the mesa 31. Prior to depositing gold as the metal, a thin adhesion layer of Ti can be deposited.

The doping concentration in the upper cladding layer 18 can be increased towards the surface in order to have a higher level at its surface where it forms an interface with the metal o the top contact layer 28, thereby to form a good Ohmic contact.

We also performed simulations to compare the maximum CW operating temperature achieved with and without a thick metal layer on the exposed outside sidewall of the ring waveguide (reference numeral 26 in the schematic drawings). Additionally, to compare the relative importance of cooling through the metal layer on the top of the mesa and the metal layer on the exposed side of the mesa, we simulated structures with and without a thick metal layer on the top.

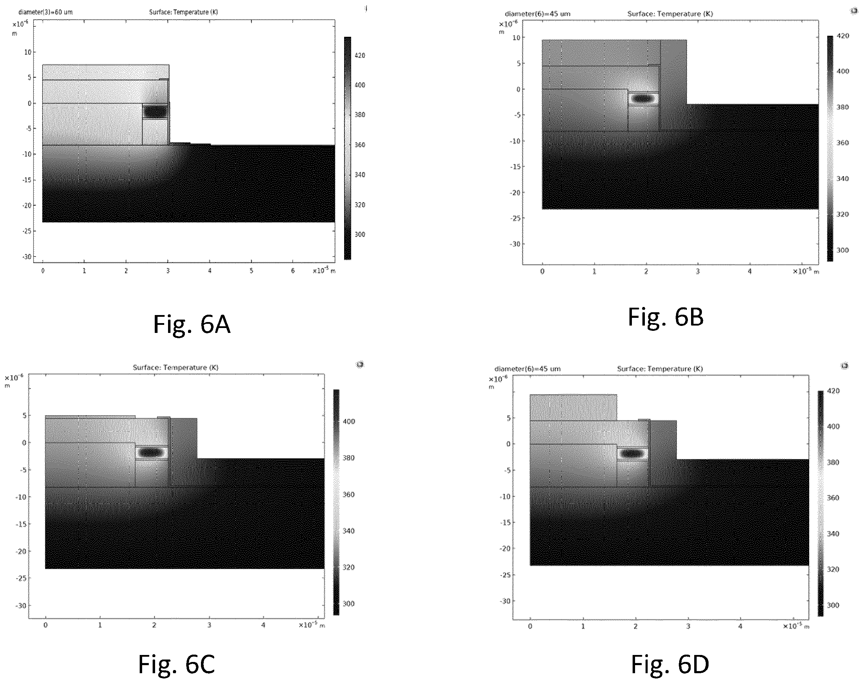

Figures 6A to 6D show the structures used for these thermal simulations. These figures originally were in colour with a colour mapping of temperature. In their monochrome copies reproduced here, the hot nature of the waveguide is still visible but the heat distribution elsewhere is no longer clear. Nevertheless, the modelled structure is clear. Figure 6A shows a reference structure which has the thin dielectric-metal mirror layers (features 22, 24 in the schematic drawings) but no thick lateral metal layer (reference numeral 26 in the schematic drawings). There is however a thick metal layer on the top contact corresponding to layer 29 in the schematic drawings. Figure 6B differs from Figure 6A in that a thick lateral metal layer 26 is added. Figure 6C differs from Figure 6B in that there is no thick metal top contact layer 29, which effectively removes the heat dissipation path out of the top of the mesa. Figure67D differs from Figure 6B in that the the diameter of the thick metal layer on the top of the mesa is reduced to correspond to the inner diameter $d_I$ of the ring waveguide to simulate whether the exposed arcuate portions (reference number 25 in the schematic drawings) cause a significant worsening of the heat dissipation. In the simulated structures, the thickness of the thick metal layers on the top contact on the sidewall of the mesa are both 5 $\mu$m and the waveguide width $W$ is 6 $\mu$m. The thin metal layers on the mesa sidewall and top contact 24, 28 have a thickness 500 nm. The dielectric layer 22 has a thickness of 300 nm. All the metal is taken to be gold. The dielectric material is $Si_3N_4$.

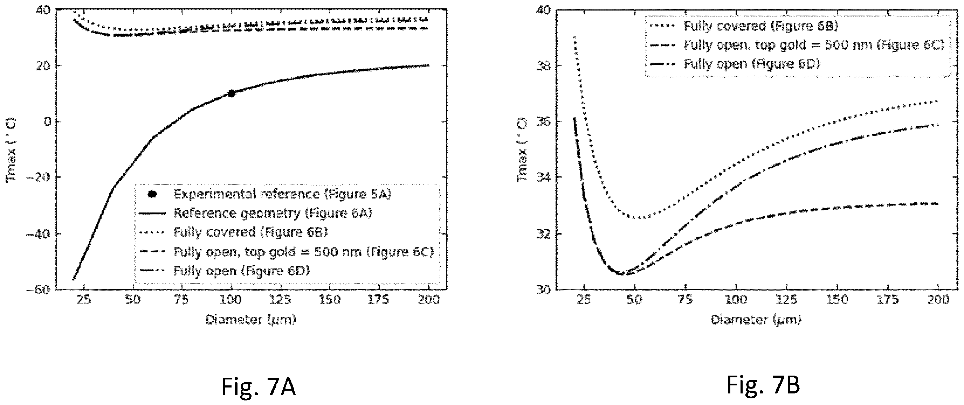

Figure 7A and 7B are two graphs plotting the same results but with Figure 7B having an expanded y-scale to better show the differences between three upper lines of Figure 7A. The graphs plot maximum CW operating temperature as a function of ring diameter for each of the structures of Figures 6A to 6D.

The continuous line (which is off scale in Figure 7B) is for the reference geometry of Figure 6A. Here it can be seen that without the thick lateral metal layer (reference numeral 26 in the schematic drawings) the maximum CW operating temperature falls quite rapidly from about +20°C to -50°C as ring diameter reduces from 200 to 25 $\mu$m. The single point, which lies on the continuous line, is the experimental reference of the contacted QCL shown in Figures 5A and 5B lasing in CW at 10 °C.

For the other three structures of Figures 6B to 6D which have in common that they all have a thick lateral metal layer the maximum CW operating temperature remains above 30°C across the whole range of ring diameters. Although the maximum CW operating temperature does fall as ring diameter reduces from 200 to 25 $\mu$m, the fall is only small and CW operation at room temperature is maintained.

Comparing the dotted and chain-dotted lines (Figures 6B & 6D respectively) it can be seen that removing the thick metal from the top contact around the whole ring (as is done for a part of the ring in the exposed arcuate portions 25) reduces the maximum CW operating temperature only by about 1 or 2°C across the whole range of ring diameters, so with the proposed structures where the top metal is removed only over a fraction of the ring the worsening in the heat dissipation is essentially insignificant.

Comparing the chain line (Figure 6C) with the dotted and chain-dotted lines (Figures 6B & 6D), it can be seen that the complete removal of the thick top metal layer 29 leaving only the thin top metal layer 28 (modelled here with a 500 nm thickness) only reduces the maximum CW operating temperature only by about 2 or 3°C across the whole range of ring diameters. This not only only shows that it is a thick lateral metal layer on the exposed outside sidewall of the ring waveguide that is dominant in heat dissipation but also that the heat dissipation that can be achieved through the top contact, even if it is made very thick, is completely ineffective when it comes to achieving the goal of reaching room temperature CW operation at small ring diameters.

In summary, our thermal simulations show that, for smaller ring diameters, e.g. less than about 100 $\mu$m, the provision of thick lateral metal layer on the exposed outside sidewall of the ring waveguide becomes crucial for achieving room temperature CW operation. Moreover, our electromagnetic simulations show that ring waveguide width is best selected to be wide enough that threshold current density is not too high whereas we know from the thermal simulations that the ring waveguide width should not be wider than necessary, since the greater the width the larger the amount of heat this needs to be dissipated and hence the lower the maximum CW operating temperature.

The ability to achieve CW operation at room temperature with smaller ring diameters, e.g. less than about 100 $\mu$m, is important for achieving single mode lasing of a WGM without distributed feedback, since at these smaller ring diameters the gain bandwidth in the active region layers (i.e. the range of wavelengths over which gain occurs) becomes comparable to the spacing of adjacent WGMs so that only one of the WGM modes dominates the lasing. The relationship between ring diameter and mode spacing as needed for natural single mode lasing without distributed feedback may be defined by when the ring waveguide has a circumference that results in the wavelength separation between adjacent ring modes being between 0.2 and 0.8 times the gain bandwidth. Moreover, it will be understood that by single mode operation we do not exclude the possibility of some small amount of power existing in other modes. This may be quantified in the following definition, for example: when operating in single mode at an optical output power of one of 0.5 mW and 1 mW, the laser has a side-mode suppression ratio of greater than 30 decibels.

In summary, we have described a ring waveguide quantum cascade laser based on whispering gallery modes. The ring waveguide is bounded radially outwards by an outside sidewall that is covered with a dielectric-metal mirror to reflect the whispering gallery modes back into the ring waveguide. and thereby reduce scattering losses. To further improve heat extraction and hence permit CW operation at room temperature, the dielectric-metal mirror can be covered with a thick metal heat extraction layer, wherein the metal mirror layer and the metal heat extraction layer together form a substantial block of metal that provides for efficient heat dissipation from the outside of the ring waveguide where the power of the whispering gallery modes is concentrated.

Suitable semiconductor materials systems for fabrication are GaAlInAs (sometimes referred to as arsenide-based) and GaAlInAsP (sometimes referred to as phosphide-based). Suitable materials for the electrodes and mirrors include Ge and the metals Au, Ti, Ni and Pt.

The upper and lower cladding layers are typically n-type doped. The active region layer sequence may be grown in either an np or pn sequence. Consequently, in different embodiments the biasing for current injection across the contacts may be in either sense. Most commonly for a QCL, the upper and lower claddings are both n-type and the top contact is the negative contact.

The active region for forming the QCL can follow any known design. For this reason, the precise layer sequence of the active region has not been described in detail. For QCLs, the most common designs are bound-to-bound, bound-to-continuum and continuum-to-continuum.

After fabrication of a wafer of QCLs according to the invention, the wafer may be diced to provide individual QCLs. Another option that follows from the surface-emitting design with a higher order Bragg grating for outcoupling is to dice the wafer to provide one- or two-dimensional arrays of QCLs. A two-dimensional array could have a simple rectangular or square grid or some other form of packing. In other embodiments, the array may be a 1D array, e.g. arranged in a line. A laser array may therefore be provided that comprises a plurality of QCLs that are formed monolithically as a single chip. This may also be useful for providing a laser array, where each laser has a different emission wavelength (e.g. through different ring diameters and/or different periodicities of the Bragg gratings) and is optionally individually drivable so that any laser in the array can be selected. This is useful for a gas sensor, since the different emission wavelengths of such a laser array can be matched to different atomic or molecular transitions for sensing different gases or different signature absorption bands of the same gas. Typical applications may be gas sensing of ambient gases (e.g. CO, $CO_2$) or sensing gas residues from explosive compounds or narcotics compounds. The close packing of lasers with different emission wavelengths may also be useful for active infrared imaging or lidar (Light Detection and Ranging) applications.

Gas sensing is an important area of application for QCLs embodying the invention, namely the QCL is a component of an absorption-based gas sensor of the type based on absorption of light by a gas molecule. Gas sensors are used in multiple industrial and scientific applications [10]. The mid-infrared part of the electromagnetic spectrum, in particular between 2.5 to 15 $\mu$m, is of interest, since it encompasses the fundamental roto-vibrational absorption lines of many light gas molecules found in the atmosphere, including numerous greenhouse gases and pollutants [9]. The absorption strength of these fundamental transitions is orders of magnitude larger compared with the higher order transitions that exist at shorter wavelengths accessible by conventional (i.e. non-cascade) laser diodes. Some example molecules and the wavelengths of their fundamental absorption lines are listed in Table 1.

**Table 1: Absorption frequencies of selected molecules in the mid-infrared.**

| Greenhouse or pollutant gas | Wavenumber [cm$^{-1}$] |
|---|---|
| Carbon monoxide (CO) | 2050 - 2300 |
| Carbon dioxide ($CO_2$) | 2350 - 2450 |
| Ozone ($O_3$) | 1000 - 1150 |
| Nitric monoxide (NO) | 1850 - 1950 |
| Nitric dioxide ($NO_2$) | 1550 - 1650 |
| Nitrous oxide ($N_2O$) | 1580 - 1630 |
| Ammonia ($NH_3$) | 1500 - 1800 |
| Methane ($CH_4$) | 1250 - 1400 |

Molecules released from solid-state substances such as narcotics or explosives could also be potentially detected, provided there are strong absorption lines in the mid-infrared.

Gas sensors of this kind measure light absorption caused by a change in the vibrational and/or rotational state of a gas molecule. The light absorbing transition is referred to as a rovibrational transition. One example is the 4.26 $\mu$m band of carbon dioxide ($CO_2$) that is generated by an asymmetric stretch. The 4.26 $\mu$m $CO_2$ band is of particular interest, since it does not coincide with strong absorption by any other common atmospheric gas.

Suitable infrared detectors for a gas sensor include photodiodes, pyroelectric, thermopile or photoacoustic detectors [10]. Example types of such sensor are the non-dispersive infrared sensor (NDIR) and the photoacoustic sensor.

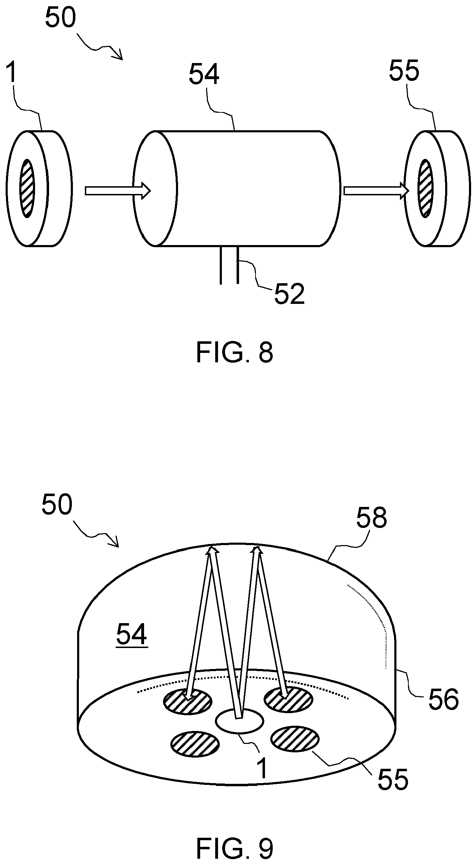

Figure 8 is a schematic perspective drawing of an example gas sensor 50 incorporating a QCL 1 according to an embodiment of the invention as the emitter. The gas sensor 50 is in a linear transmission configuration in which the emitter 1 outputs a laser beam that traverses a gas cell 54 of cylindrical shape that contains a gas to be sensed and is then incident on an infrared detector 55. Gas to be sensed may be introduced into and removed from the gas cell 54 via a port 52.

Figure 9 is a schematic perspective drawing of an example gas sensor 50 incorporating a QCL 1 according to an embodiment of the invention as the emitter. The gas sensor 50 is in a planar reflection configuration in which the gas to be sensed is contained in a gas cell 54 formed from a planar base 56 in combination with a reflective dome 58 which has an ellipsoid shape. The planar base 56 has mounted therein the emitter 1 and also a plurality of infrared detectors 55. The emitter 1 outputs a divergent laser beam upwards into the gas cell 54, the laser beam then being reflected from the underside of the dome 58 whereupon it traverses the gas cell 54 again in a downwards direction and is incident on the infrared detectors 55.

In a LIDAR gas sensor, it will be appreciated that a gas cell is not present. Rather a small proportion of the emitted light is backscattered and detected.

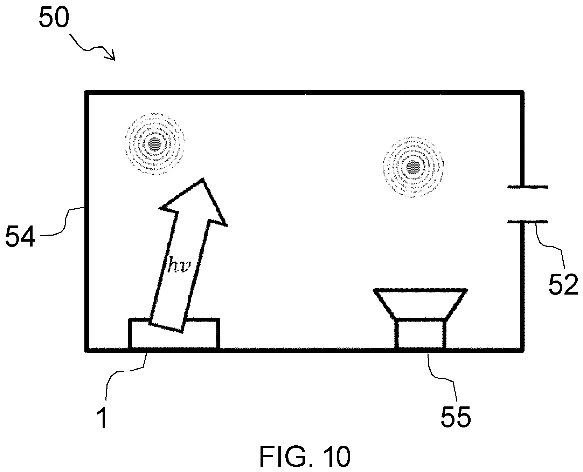

Figure 10 is a schematic drawing of an example photoacoustic gas sensor 50 incorporating a QCL according to an embodiment of the invention as the emitter 1. The QCL 1 outputs a laser beam that excites the gas present in the cell 54. A pressure wave is generated through nonradiative scattering of the molecules, as indicated schematically by the concentric circles around two example molecules. The pressure wave can be detected with an acoustic detector 56 such as a microphone or a quartz-tuning fork. The gas cell 54 may be provided with a suitable port 52 to introducing (and removing) a gas to be sensed into the gas cell 54.

Another gas sensor configuration that could be used with QCLs according to the invention (not shown) is an elliptical gas cell as disclosed in Tan *et al* [11] - see in particular Figs. 3 to 5 thereof. This gas sensor has a single infrared source and multiple detectors with different filter windows. The source and detectors are arranged inside a complex multiple half-ellipsoid mirror surface that is capped by a flat dome to form a cell for the gas to be sensed. The infrared source is located at the intersection of the ellipses of the ellipsoidal mirror surface. The detectors are arranged at focal points of respective ellipsoid mirror portions of the mirror surface. Light from the infrared source is emitted upwards, scattered back from the dome surface and then reflected by the ellipsoidal mirror surfaces into the detectors. A QCL according to the invention would replace the source at the intersection of the ellipses, as shown in this publication, or alternatively multiple QCLs according to the invention could be placed at the intersection of the ellipses for a sensor capable of detecting multiple gas species.

A gas sensor incorporating a cascade laser as described herein may be incorporated in an Internet of Things (IoT) sensor device. The low power consumption of the cascade lasers disclosed herein means that they are suitable for battery powered operation with a long battery lifetime, e.g. several years. An IoT gas sensor device may include a battery for powering the gas sensor as well as further ancillary components such as a wireless transceiver operable to transmit the detector signal and/or the concentration of gas molecules to a remote receiver. One example commercial product is the CA-8210 transceiver chip from Cascoda Limited. Other known IoT sensor components may also be included for known functions, such as for energy harvesting to directly power the electronic components and/or recharge the battery.

It will be clear to one skilled in the art that many improvements and modifications can be made to the foregoing exemplary embodiment without departing from the scope of the present disclosure.

REFERENCE NUMERALS

| | |
|---|---|
| 1 | quantum cascade laser (QCL) |
| 2 | ring waveguide |
| 10 | substrate - also acting as lower outer cladding layer (n:InP) |
| 12 | lower cladding layer, inner (n:InGaAs) |
| 14 | active region layers (MQW structure InGaAs/AlInAs) |
| 16 | upper cladding layer, inner (n:InGaAs) |
| 18 | upper cladding layer, outer (n:InP) |
| 20 | base/bottom contact layer (metallization; Ge/Au/Ni/Au) |
| 22 | dielectric layer for mirror ($Si_3N_4$ or $Al_2O_3$) |
| 23 | lateral extensions of metal layer 26 |
| 24 | (thin) metal layer for mirror (metallization; Ti/Au) |
| 25 | exposed arcuate portions of the ring waveguide |
| 26 | (thick) metal layer for lateral/radial heat extraction (electroplated Au) |

EP 4 329 113 A1

27   buried arcuate portions of the ring waveguide
28   top contact layer (metallization; Ti/Pt/Au)
29   metal layer for contacting and vertical heat extraction (electroplated Au)
30   mesa top surface (of semiconductor heterostructure)
31   outside sidewall of ring waveguide, exposed
32   bottom surface (of semiconductor heterostructure)
33   inside sidewall of ring waveguide, buried
34   etched upper surface of substrate
35   radially extending ribs of higher order Bragg grating
36   insulating layer (regrown InP:Fe)
37   top metal layer for base contact (electroplated Au)
40   ring-shaped trench
50   gas sensor
52   gas port
54   gas cell
55   infrared detector
56   gas sensor base
58   gas sensor dome

REFERENCES

1. Jerôme Faist, Claire Gmachl, Marinella Striccoli, Carlo Sirtori, Federico Capasso, Deborah L. Sivco, and Alfred Y. Cho "Quantum cascade disk lasers" Appl. Phys. Lett. 69, 2456 (1996); https://doi.org/10.1063/1.117496

2. Claire Gmachl, Jerôme Faist, Federico Capasso, Carlo Sirtori, Deborah L. Sivco and Alfred Y. Cho "Long-Wavelength (9.5-11.5 $\mu$m) Microdisk Quantum-Cascade Lasers" IEEE JQE, 33, 1567 (1997) DOI: 10.1109/3.622638

3. Elvis Mujagic, Michele Nobile, Hermann Detz, Werner Schrenk, Jianxin Chen, Claire Gmachl and Gottfried Strasser "Ring cavity induced threshold reduction in single-mode surface emitting quantum cascade lasers" Appl. Phys. Lett. 96, 031111 (2010); https://doi.org/10.1063/1.3292021

4. Austrian Patent Application in the name of TU Wien with inventors Elvis Mujagic, Gottfried Strasser and Leonard Hoffmann, Publication Number AT511032A1

5. Y. Bai, S. Tsao, N. Bandyopadhyay, S. Slivken, Q. Y. Lu, D. Caffey, M. Pushkarsky, T. Day and M. Razeghi "High power, continuous wave, quantum cascade ring laser" Appl. Phys. Lett. 99, 261104 (2011); https://doi.org/10.1063/1.3672049

6. Wu, D. H., Razeghi, M. High power, low divergent, substrate emitting quantum cascade ring laser in continuous wave operation. APL Materials 5, 035505 (2017); https://doi.org/10.1063/1.4978810

7. Qiangqiang Guo, Jinchuan Zhang, Chao Ning, Ning Zhuo, Shenqiang Zhai, Junqi Liu, Lijun Wang, Shuman Liu, Zhiwei Jia and Fengqi Liu "Continuous-Wave Operation of Microcavity Quantum Cascade Lasers in Whispering-Gallery Mode" ACS Photonics 2022, 9, 1172-1179; https://doi.org/10.1021/acsphotonics.1c01437

8. Qiangqiang Guo, Jinchuan Zhang, Ray Yin, Ning Zhuo, Quanyong Lu, Shenqiang Zhai, Junqi Liu, Lijun Wang, Shuman Liu, and Fengqi Liu "Continuous-wave microcavity quantum cascade lasers in whispering-gallery modes up to 50 °C" Optics Express 2022, 30, 13, pp. 22671-22678 https://doi.org/10.1364/OE.458589

9. I. E. Gordon, L. S. Rothman, C. Hill, R. V. Kochanov, Y. Tan, P. F. Bernath, M. Birk, V. Boudon, A. Campargue, K. V. Chance, B. J. Drouin, J. M. Flaud, R. R. Gamache, J. T. Hodges, D. Jacquemart, V. I. Perevalov, A. Perrin, K. P. Shine, M. A. Smith, J. Tennyson, G. C. Toon, H. Tran, V. G. Tyuterev, A. Barbe, A. G. Cs'asz'ar, V. M. Devi, T. Furtenbacher, J. J. Harrison, J. M. Hartmann, A. Jolly, T. J. Johnson, T. Karman, I. Kleiner, A. A. Kyuberis, J. Loos, O. M. Lyulin, S. T. Massie, S. N. Mikhailenko, N. Moazzen-Ahmadi, H. S. Müller, O. V. Naumenko, A. V. Nikitin, O. L. Polyansky, M. Rey, M. Rotger, S. W. Sharpe, K. Sung, E. Starikova, S. A. Tashkun, J. V. Auwera, G. Wagner, J. Wilzewski, P. Wcis lo, S. Yu, and E. J. Zak. The HITRAN2016 molecular spectroscopic database, Journal of Quantitative Spectroscopy and Radiative Transfer, vol. 203, pp. 3-69, 12 2017. 5, 208 https://doi:10.1016/J.JQSRT.2017.06.038

10. Popa, D., & Udrea, F. (2019). Towards integrated mid-infrared gas sensors. Sensors (Switzerland), 19(9). https://doi.org/10.3390/s19092076

11. Qiulin Tan, Licheng Tang, Mingliang Yang, Chenyang Xue, Wendong Zhang, Jun Liu, Jijun Xiong, Three-gas detection system with IR optical sensor based on NDIR technology, Optics and Lasers in Engineering, Volume 74, 2015, Pages 103-108, ISSN 0143-8166, https://doi.org/10.1016/j.optlaseng.2015.05.007

**Claims**

1. A quantum cascade laser (1) configured to emit a laser beam at a lasing wavelength, $\lambda$ , the laser comprising:

   a ring waveguide (2) configured to support whispering gallery modes, the ring waveguide being bounded radially outwards by an outside sidewall (31) and vertically upwards and downwards by refractive index differences between horizontally extending semiconductor layers of a semiconductor stack (10-18) including active region layers (14);
   top and bottom contacts (20, 28) arranged to provide for carrier injection vertically across the active region layers;
   a higher order Bragg grating (35) of order two or greater formed around the ring waveguide, or at least around one arcuate portion thereof, and above the active region layers to couple light at the lasing wavelength upwards out of the ring waveguide to form the laser beam; and
   a mirror (22, 24) formed on the outside sidewall by a dielectric mirror layer (22) and a metal mirror layer (24), the mirror being configured to reflect the whispering gallery modes back into the ring waveguide.

2. The laser of claim 1, wherein the outside sidewall of the ring waveguide is formed by a ring-shaped trench (40) etched in the semiconductor stack.

3. The laser of claim 1, wherein the outside sidewall of the ring waveguide is formed by a ring-shaped mesa etched in the semiconductor stack.

4. The laser of any preceding claim, wherein the ring waveguide is bounded radially inwards by an inside sidewall (33) that is a buried interface that interfaces with a horizontally extending central layer (36) of insulating semiconductor material to confine the carrier injection to taking place vertically across the active region layers.

5. The laser of any preceding claim, further comprising:
   a metal heat extraction layer (26) formed on the metal mirror layer, wherein the metal mirror layer and the metal heat extraction layer have a joint thickness in the radial direction of at least one of 0.5, 1.0, 1.5, 2.0, 2.5 and 3.0 micrometres.

6. The laser of claim 5, wherein the metal mirror layer and the metal heat extraction layer are formed integrally as one and the same layer.

7. The laser of any preceding claim, wherein the mirror further comprises one or more additional dielectric and metal mirror layers.

8. The laser of any of claims 1 to 7, wherein the ring waveguide includes exposed and buried arcuate portions (25, 27), there being at least one of each, the exposed arcuate portions (25) forming windows for coupling out laser light scattered by the higher order Bragg grating (35) and the buried arcuate portions (27) being buried by electrically conductive material and acting as the top contact for current injection.

9. The laser of any of claims 1 to 7, wherein the ring waveguide includes an exposed ring surface forming a ring-shaped window for coupling out laser light scattered by the higher order Bragg grating.

10. The laser of any of claims 1 to 9, wherein the higher order Bragg grating is formed by radially extending ribs of semiconductor material buried in or between semiconductor layers of the semiconductor stack.

11. The laser of any of claims 1 to 9, wherein the higher order Bragg grating is formed by radially extending ribs etched out of at least one semiconductor layer that lies above the active region layers.

12. The laser of any preceding claim, wherein the waveguide width is in the range between $\lambda/n_{eff}$, where $n_{eff}$ is the effective refractive index of the ring waveguide at the lasing wavelength, and a multiple thereof of one of 1.5, 2.0, 2.5 and 3.0.

13. The laser of any preceding claim, wherein the active region layers form a gain medium having a range of wavelengths over which gain is possible, referred to as the gain bandwidth, and wherein the ring waveguide has a circumference that results in the wavelength separation between adjacent whispering gallery modes being between 0.2 and 0.8 times the gain bandwidth.

14. The laser of claim 13, wherein the ring waveguide circumference is between one of 20, 30, 40 or 50 μm and 200, 300, 400, 500, 600 and 700 μm as measured geometrically around the outside sidewall.

15. A method of manufacturing a quantum cascade laser (1) configured to emit a laser beam at a lasing wavelength, A, the method comprising:

  providing a semiconductor substrate (10);
  forming a semiconductor stack by:

    depositing a lower cladding layer (12);
    depositing a sequence of active region layers (14); and
    depositing an upper cladding layer (16, 18);

  etching into the semiconductor stack at least as far as through the active region layers to define an outside sidewall (31) and an inside sidewall (33) for a ring waveguide (2) capable of supporting whispering gallery modes;
  forming a higher order Bragg grating (35) of order two or greater around the ring waveguide, or at least around one arcuate portion thereof, and above the active region layers to couple light at the lasing wavelength upwards out of the ring waveguide to form the laser beam;
  forming top and bottom contacts (20, 28) to provide for carrier injection vertically across the active region layers;
  depositing a dielectric layer (22) on the outside sidewall (31); and
  depositing a metal layer (24) on the dielectric layer (22), the metal layer and the dielectric layer together forming a mirror configured to reflect whispering gallery modes supported by the ring waveguide.

Fig. 1A

EP 4 329 113 A1

Fig. 1B

Fig. 1C

EP 4 329 113 A1

Fig. 1D

Fig. 1E

Fig. 2

Fig. 3

Fig. 4

Fig. 5B

Fig. 5A

Fig. 5C

Fig. 6A

Fig. 6B

Fig. 6C

Fig. 6D

Fig. 7B

Fig. 7A

FIG. 8

FIG. 9

FIG. 10

Europäisches
Patentamt
European
Patent Office
Office européen
des brevets

# EUROPEAN SEARCH REPORT

Application Number

EP 22 19 1387

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MUJAGIC E. ET AL: "Coherence and beam shaping in quantum cascade lasers", SPIE SMART STRUCTURES AND MATERIALS + NONDESTRUCTIVE EVALUATION AND HEALTH MONITORING, 2005, SAN DIEGO, CALIFORNIA, UNITED STATES, vol. 7230, 5 February 2009 (2009-02-05), page 723015, XP093020599, US ISSN: 0277-786X, DOI: 10.1117/12.808466 ISBN: 978-1-5106-4548-6 | 1-3,5-15 | INV. H01S5/10 H01S5/187 H01S5/34 |
| Y | * page 2, paragraph 2 - page 3, paragraph 1; figures 1a,1c * * page 3, paragraph 3 - page 4, paragraph 2 * * page 4, paragraph 4-5; figure 3 * | 4 | |
| A,D | AT 511 032 B1 (UNIV WIEN TECH [AT]) 15 February 2013 (2013-02-15) * paragraphs [0044], [0045]; figures 2-4 * | 1,15 | |
| Y,D | GUO QIANGQIANG ET AL: "Continuous-Wave Operation of Microcavity Quantum Cascade Lasers in Whispering-Gallery Mode", ACS PHOTONICS, vol. 9, no. 4, 14 March 2022 (2022-03-14), pages 1172-1179, XP093019713, ISSN: 2330-4022, DOI: 10.1021/acsphotonics.1c01437 * abstract * * page 1173, right-hand column - page 1175, left-hand column; figures 1,4 * | 4 | TECHNICAL FIELDS SEARCHED (IPC) H01S |
| A | US 2011/080931 A1 (TREDICUCCI ALESSANDRO [IT] ET AL) 7 April 2011 (2011-04-07) | 1,15 | |

The present search report has been drawn up for all claims

| Place of search | Date of completion of the search | Examiner |
|---|---|---|
| Munich | 14 February 2023 | Riechel, Stefan |

EPO FORM 1503 03.82 (P04C01)

## ANNEX TO THE EUROPEAN SEARCH REPORT
## ON EUROPEAN PATENT APPLICATION NO.

EP 22 19 1387

This annex lists the patent family members relating to the patent documents cited in the above-mentioned European search report.
The members are as contained in the European Patent Office EDP file on
The European Patent Office is in no way liable for these particulars which are merely given for the purpose of information.

14-02-2023

| Patent document cited in search report | | Publication date | Patent family member(s) | | Publication date |
|---|---|---|---|---|---|
| AT 511032 | B1 | 15-02-2013 | NONE | | |
| US 2011080931 | A1 | 07-04-2011 | EP 2286493 | A1 | 23-02-2011 |
| | | | US 2011080931 | A1 | 07-04-2011 |
| | | | WO 2009136244 | A1 | 12-11-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- AT 511032 A1, Elvis Mujagic, Gottfried Strasser and Leonard Hoffmann

**Non-patent literature cited in the description**

- **JERÔME FAIST ; CLAIRE GMACHL ; MARINELLA STRICCOLI ; CARLO SIRTORI ; FEDERICO CAPASSO ; DEBORAH L. SIVCO ; ALFRED Y. CHO.** Quantum cascade disk lasers. *Appl. Phys. Lett.,* 1996, vol. 69, 2456, https://doi.org/10.1063/1.117496
- **CLAIRE GMACHL ; JERÔME FAIST ; FEDERICO CAPASSO ; CARLO SIRTORI ; DEBORAH L. SIVCO ; ALFRED Y. CHO.** Long-Wavelength (9.5-11.5 $\mu$m) Microdisk Quantum-Cascade Lasers. *IEEE JQE,* 1997, vol. 33, 1567
- **ELVIS MUJAGIC ; MICHELE NOBILE ; HERMANN DETZ ; WERNER SCHRENK ; JIANXIN CHEN ; CLAIRE GMACHL ; GOTTFRIED STRASSER.** Ring cavity induced threshold reduction in single-mode surface emitting quantum cascade lasers. *Appl. Phys. Lett.,* 2010, vol. 96, 031111, ttps://doi.org/10.1063/1.3292021
- **Y. BAI ; S. TSAO ; N. BANDYOPADHYAY ; S. SLIVKEN ; Q. Y. LU ; D. CAFFEY ; M. PUSHKARSKY ; T. DAY ; M. RAZEGHI.** High power, continuous wave, quantum cascade ring laser. *Appl. Phys. Lett.,* 2011, vol. 99, 261104, https://doi.org/10.1063/1.3672049
- **WU, D. H. ; RAZEGHI, M.** High power, low divergent, substrate emitting quantum cascade ring laser in continuous wave operation. *APL Materials,* 2017, vol. 5, 035505, https://doi.org/10.1063/1.4978810

- **QIANGQIANG GUO ; JINCHUAN ZHANG ; CHAO NING ; NING ZHUO ; SHENQIANG ZHAI ; JUNQI LIU ; LIJUN WANG ; SHUMAN LIU ; ZHIWEI JIA ; FENGQI LIU.** Continuous-Wave Operation of Microcavity Quantum Cascade Lasers in Whispering-Gallery Mode. *ACS Photonics,* 2022, vol. 9, 1172-1179, https://doi.org/10.1021/acsphotonics.1c01437
- **QIANGQIANG GUO ; JINCHUAN ZHANG ; RAY YIN ; NING ZHUO ; QUANYONG LU ; SHENQIANG ZHAI ; JUNQI LIU ; LIJUN WANG ; SHUMAN LIU ; FENGQI LIU.** Continuous-wave microcavity quantum cascade lasers in whispering-gallery modes up to 50 °C. *Optics Express,* 2022, vol. 30 (13), 22671-22678, https://doi.org/10.1364/OE.458589
- **I. E. GORDON ; L. S. ROTHMAN ; C. HILL ; R. V. KOCHANOV ; Y. TAN ; P. F. BERNATH ; M. BIRK ; V. BOUDON ; A. CAMPARGUE ; K. V. CHANCE.** The HITRAN2016 molecular spectroscopic database. *Journal of Quantitative Spectroscopy and Radiative Transfer,* 05 December 2017, vol. 203, 3-69, https://doi:10.1016/J.JQSRT.2017.06.038
- **POPA, D. ; UDREA, F.** Towards integrated mid-infrared gas sensors. *Sensors (Switzerland,* 2019, vol. 19 (9, https://doi.org/10.3390/s19092076
- **QIULIN TAN ; LICHENG TANG ; MINGLIANG YANG ; CHENYANG XUE ; WENDONG ZHANG ; JUN LIU ; JIJUN XIONG.** Three-gas detection system with IR optical sensor based on NDIR technology. *Optics and Lasers in Engineering,* 2015, vol. 74, ISSN 0143-8166, 103-108, https://doi.org/10.1016/j.optlaseng.2015.05.007